(19) Europäisches Patentamt

European Patent Office

Office européen des brevets

(11) **EP 1 632 886 A1**

(12) **EUROPEAN PATENT APPLICATION**

(43) Date of publication:
08.03.2006 Bulletin 2006/10

(51) Int Cl.:
*G06K 19/077* (2006.01)   *H05K 1/11* (2006.01)
*H01R 13/24* (2006.01)

(21) Application number: 05018993.5

(22) Date of filing: 01.09.2005

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **07.09.2004  US 607344 P**
**27.07.2005  US 190230**

(71) Applicants:
• **Richip Incorporated**
  **Jhubei City, Hsinchu County 302 (TW)**
• **C-One Technology Corp.**
  **Hsinchu**
  **300 (TW)**
• **Carry Computer Eng. Co., Ltd.**
  **Tapei 231 (TW)**
• **Industrial Technology Research Institute**
  **Chutung**
  **Hsin chu 310 (TW)**
• **ASUSTek Computer Incorporated**
  **Beitou Zapei**
  **112 (TW)**

• **DBTEL Incorporated**
  **Tucheng City**
  **T'ai pei 236 (TW)**
• **Power Digital Card Co., Ltd.**
  **Sindian City**
  **T'ai pei 231 (TW)**

(72) Inventors:
• **Yu, Gordon**
  **Taipei,**
  **Taiwan 105 (CN)**
• **Hsieh, Hsiang-An**
  **Taipei County,**
  **Taiwan 220 (CN)**
• **Ho, Hung Tse,**
  **6F., No. 2, Alley 22,**
  **Sinyi District, Taipei,**
  **Taiwan 110 (CN)**

(74) Representative: **Maucher, Wolfgang et al**
**Patent- und Rechtsanwaltssozietät**
**Maucher, Börjes-Pestalozza,**
**Dreikönigstrasse 13**
**79102 Freiburg i. Br. (DE)**

(54) **Interface for a removable electronic device**

(57)   A removable electronic device having an application module for transferring data to or from a host having a plurality of contact terminals, the device comprising a first row of contact pads, each of the contact pads of the first row including a substantially tapered end, and a second row of contact pads, each of the contact pads of the second row including a substantially tapered end that corresponds to the substantially tapered end of at least one of the contact pads of the first row in an interweaving relationship, wherein the first and second rows of contacts pads are configured to receive the plurality of contact terminals.

FIG. 5

EP 1 632 886 A1

**Description**

CROSS-REFERENCE TO RELATED APPLICATIONS

This application claims the benefit of U.S. Provisional Application No. 60/607,344, filed September 7, 2004, which is herein incorporated by reference in its entirety.

BACKGROUND OF THE INVENTION

The present invention relates generally to a removable electronic device and, more particularly, to a removable memory card standard and method thereof.

A memory card is commonly known as a small portable package containing digital memory, such as an array of non-volatile memories, such as flash memories, EPROMs, or EEPROMs (electrically erasable and programmable read only memory). Memory cards have gain popularity as a device for storing a substantial amount of bytes of data from personal computers, notebook computers, personal electronic assistants, cellular telephones, cameras and other electronic devices that support removable data storage.

In general, a memory card includes exposed electrical contacts on its surface to allow easy connection to and removal from a receptacle of a host electronic system or device, particularly portable devices. A number of standards for a memory card have been implemented, including the MultiMedia Card ("MMC") by the MultiMedia Card Association ("MMCA") of Cupertino, California. An MMC is a compact, removable memory card for storing and retrieving digital information in small, low power devices. MMC has been used in many mobile electronic applications, such as music players, mobile phones, personal digital assistants (PDAs), digital cameras, voice recorders, and GPS navigation devices. The MMCA developed and regulated its open industry standards, and also defined all types of MMCs as an industry standard across multiple host platforms and markets. The physical and electrical specifications for the MMC are given in "The MultiMediaCard System Specification" that is updated and published from time-to-time by the MMCA.

Another known standard for a removable memory card, although not limited to memory storage, is the Universal Serial Bus ("USB"). USB is a high-speed serial bus that supports devices such as printers, keyboards, scanners, pointing devices, and PDAs. USB has become a standard within the computer industry as this protocol affords networking of multiple devices with minimal connections and increased user friendliness. USB is currently defined by the Universal Serial Bus Specification, written and controlled by USB Implementers Forum, Inc., a non-profit corporation founded by a group of companies that developed the USB specification. The specification covers all aspects of USB operations, including electrical, mechanical, and communications characteristics and specifications. One significant feature of the USB is that it allows a peripheral device to store information about itself, and to provide such information upon request by the host. This obviates the need for the host, be it a computer, operating system, or application program, to maintain this information for many different devices. Instead, the device itself stores and provides the information.

In the evolution of memory cards, it is desirable to have memory cards that consumes low power and provides higher speed for accessing, while still retaining backward compatibility with existing protocols such as the MMC and USB specifications.

BRIEF SUMMARY OF THE INVENTION

A novel removable memory card standard is disclosed. The standard of the present invention includes both detection schemes and hardware interface compatibility requirements. Furthermore, the novel standard is backward compatible with the MMC and USB applications.

In accordance with an embodiment of the present invention, there is provided a removable electronic device having an application module for transferring data to or from a host having a plurality of contact terminals, the device comprising a first row of contact pads, each of the contact pads of the first row including a substantially tapered end, and a second row of contact pads, each of the contact pads of the second row including a substantially tapered end that corresponds to the substantially tapered end of at least one of the contact pads of the first row in an interweaving relationship, wherein the first and second rows of contacts pads are configured to receive the plurality of contact terminals.

Further in accordance with the present invention, there is provided a removable electronic device having an application module for transferring data to or from a host, the device comprising a housing having a top surface, a bottom surface and a periphery, a plurality of rows of interweaving contact pads formed on the top surface of the housing, a substantially U-shaped indentation on the periphery of the housing, and a notch on a corner of the housing for securing the device to the host when the device is connected to the host.

Also in accordance with the present invention, there is provided a removable electronic device having an application module for transferring data to or from a host, the device comprising a housing having a top surface, a bottom surface and a periphery, a substantially U-shaped indentation on the periphery of the housing, and a notch on a corner of the housing for securing the device to the host when the device is connected to the host.

Still in accordance with the present invention, there is provided a removable electronic device having an application module for transferring data to or from a host, the device comprising a housing having a top surface, a bottom surface and a periphery, a plurality of rows of interweaving contact pads formed on the top surface of the housing, and a substantially U-shaped indentation on the periphery of the housing.

Yet still in accordance with the present invention, there is provided a removable electronic device having an application module for transferring data to or from a host, the device comprising a housing having a top surface, a bottom surface and a periphery, a plurality of rows of interweaving contact pads formed on the top surface of the housing, and a notch on a corner of the housing for securing the device to the host when the device is connected to the host.

Additional features and advantages of the present invention will be set forth in part in the description which follows, and in part will be obvious from the description, or may be learned by practice of the invention. The features and advantages of the invention will be realized and attained by means of the elements and combinations particularly pointed out in the appended claims.

It is to be understood that both the foregoing general description and the following detailed description are exemplary and explanatory only and are not restrictive of the invention, as claimed.

The accompanying drawings, which are incorporated in and constitute a part of this specification, illustrate one embodiment of the present invention and together with the description, serves to explain the principles of the invention.

BRIEF DESCRIPTION OF THE SEVERAL VIEWS OF THE DRAWINGS

The foregoing summary, as well as the following detailed description of the invention, will be better understood when read in conjunction with the appended drawings. For the purpose of illustrating the invention, there are shown in the drawings embodiments which are presently preferred. It should be understood, however, that the invention is not limited to the precise arrangements and instrumentalities shown.

In the drawings:

Figs. 1A, 1B and 1C are functional block diagrams of the general applications of a memory card in accordance with one embodiment of the present invention;;

Fig. 2 is a flow diagram of a method for detecting a mode of operation in accordance with one embodiment of the present invention;

Fig. 3 is another flow diagram of a method for detecting a mode of operation in accordance with one embodiment of the present invention;

Fig. 4A is a proposed pin assignment chart of a removable electronic device in accordance with one embodiment of the present invention;

Fig. 4B is a proposed pin assignment chart of a removable electronic device in accordance with another embodiment of the present invention;

Fig. 5 is a diagram of a removable electronic device in accordance with one embodiment of the present invention; and

Figs. 6A and 6B show exemplary electronic devices in accordance with embodiments of the present invention.

DETAILED DESCRIPTION OF THE INVENTION

In this detailed description, for purposes of explanation, numerous specific details are set forth to provide a thorough understanding of embodiments of the present invention. One skilled in the art will appreciate, however, that embodiments of the present invention may be practiced without these specific details. In other instances, structures and devices are shown in block diagram form. Furthermore, one skilled in the art can readily appreciate that the specific sequences in which methods are presented and performed are illustrative and it is contemplated that the sequences can be varied and still remain within the spirit and scope of embodiments of the present invention.

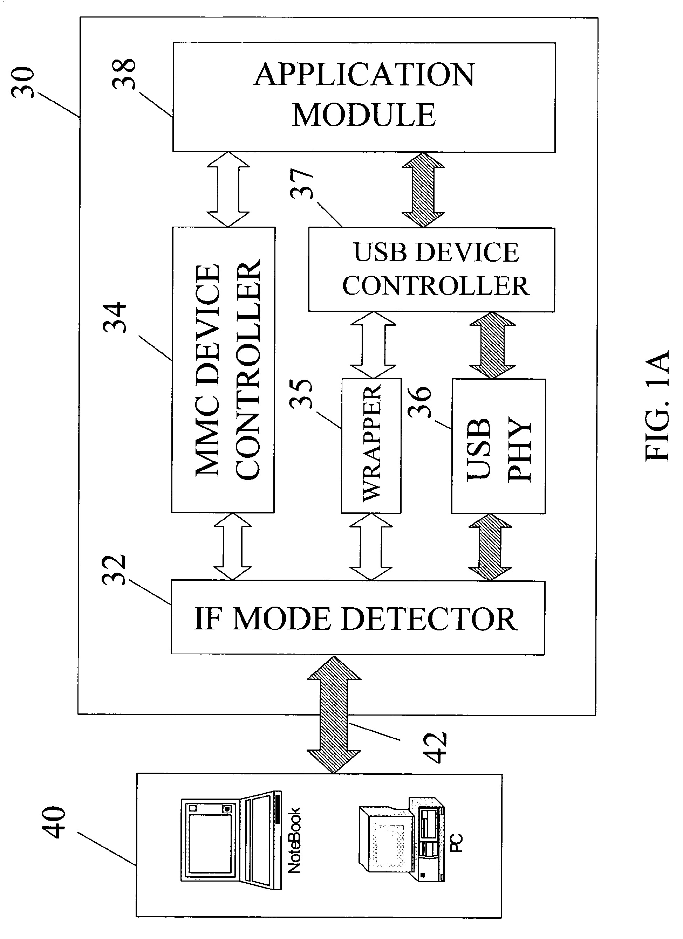

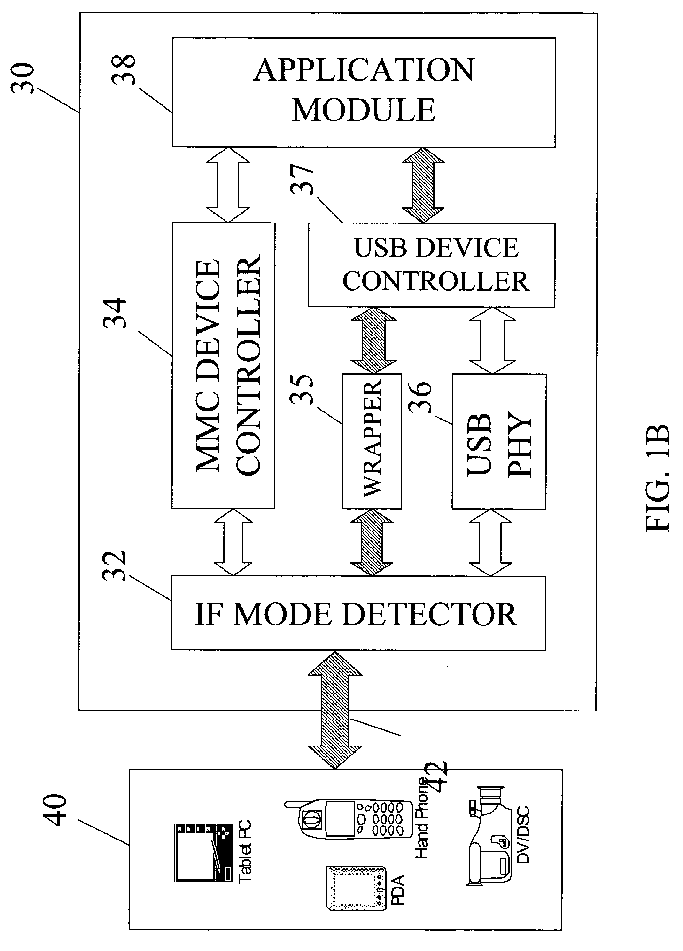

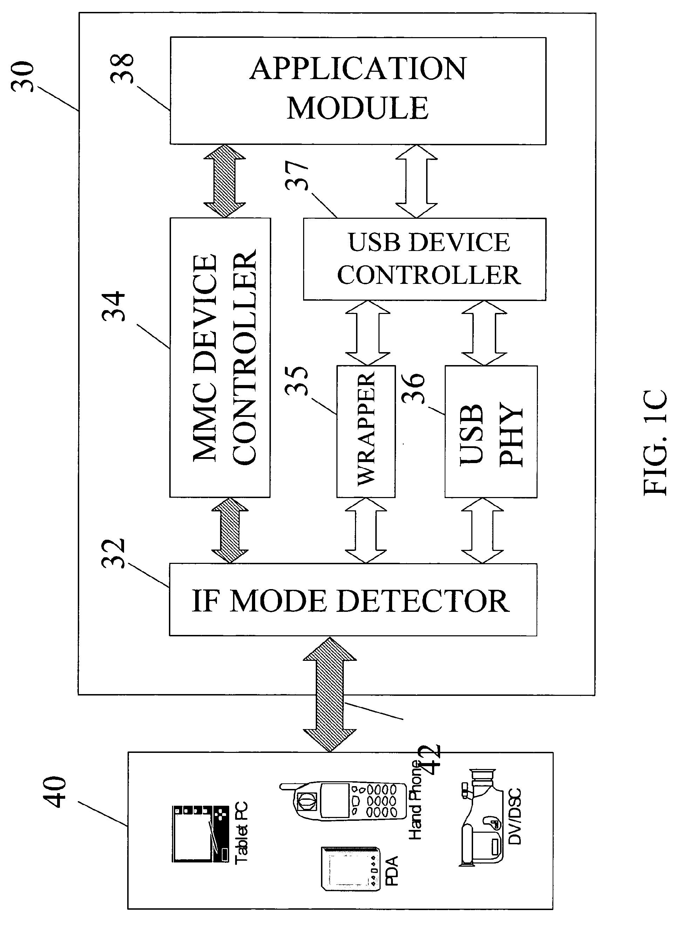

Figs. 1A, 1B and 1C are functional block diagrams of general applications of a removable electronic device 30 in accordance with one embodiment of the present invention. Electronic device 30, tentatively named the "Mu Card," which is able to support modes of operations compatible with USB and at least one of MMC, CF (compact flash), SM (smart media) and SD (security digital) applications. For example, the USB compatible mode includes USB 2.0 application, and the MMC compatible mode includes one of MMC 4.0 or MMC SPI (serial-peripheral interface) applications. For the purpose of simplicity, only the MMC compatible mode is illustrated in the following embodiments. Skilled persons in the art will understand that the present invention is equally applicable to the CF, SM and SD modes.

Electronic device 30 includes a 1-, 4-, 8- or 16-bit interface, and provides low voltage support of 5V/3.3V/1.8V, with zero power consumption during standby. In addition, electronic device 30 is able to support a wide bandwidth from approximately 50KB/s to 120MB/s. In contrast, MMC 4.0 supports 1-, 4- or 8-bit data transfer at a maximum speed of 52 MB/sec, and USB 2.0 supports data transfer at a maximum speed of 60 MB/sec. Consequently, electronic device 30 provides high-speed applications while retaining backward compatibility at least with regard to USB, MMC and MMC SPI applications.

Fig. 1A is a functional block diagram of electronic device 30 operating in a USB mode. Referring to Fig. 1A, electronic device 30 includes an interface (IF) mode detector 32, a multi-media card (MMC) device controller 34, a wrapper 35, a universal serial bus (USB) physical layer (PHY) circuit 36, a USB device controller 37, and an application module 38. IF mode detector 32 detects a mode of operation to distinguish among an MMC mode, a USB mode or a Mu mode when electronic device 30 is inserted into a host 40. Host 40, for example, a notebook, a personal computer (PC), a cell phone, a tablet PC, a PDA or a DV/DSC, may include a card reader (not shown) for receiving electronic device 30. In the present embodiment, IF mode detector 32 detects whether a host 40, to which electronic device 30 is connected, is in compliance with the USB specifications. USB device controller 37 controls data transfer over a common bus 42 between host 40 and application module 38 via USB PHY circuit 36. Application module 38 functions to serve as a memory storage or an input/output (I/O) interface, depending on the operation mode detected.

Fig. 1B is a functional block diagram of electronic device 30 operating in a Mu mode. Referring to Fig. 1B, IF mode detector 32 detects that a host 40, to which electronic device 30 is connected, is in compliance with the Mu specifications. USB device controller 37 controls data transfer between host 40 and application module 38 via wrapper 35. Wrapper 35, which wraps a call to a function or program inside another function or program, functions to convert 16-bit data into serial data recognizable by USB device controller 37, or vice versa. As such, wrapper 35 functions to bridge between a Mu bus and a UTMI (USB 2.0 Transceiver Macrocell Interface) bus. UTMI, which has been developed to define the interface specifications of the physical layer circuits and part of the logical layer circuits of the USB 2.0, enables a data transfer rate of 480 Mbps in high speed (HS) mode, which is significantly higher than that of the USB 1.1, while maintaining backward compatibility with the USB 1.1 standard.

Fig. 1C is a functional block diagram of electronic device 30 operating in an MMC mode. Referring to Fig. 1C, 1F mode detector 32 detects that a host 40, to which electronic device 30 is connected, is in compliance with the MMC specifications. MMC device controller 34 controls data transfer between host 40 and application module 38. The MMC application includes one of MMC 4.0, a 1-, 4- or 8-bit interface, or MMC SPI, a 1-bit interface.

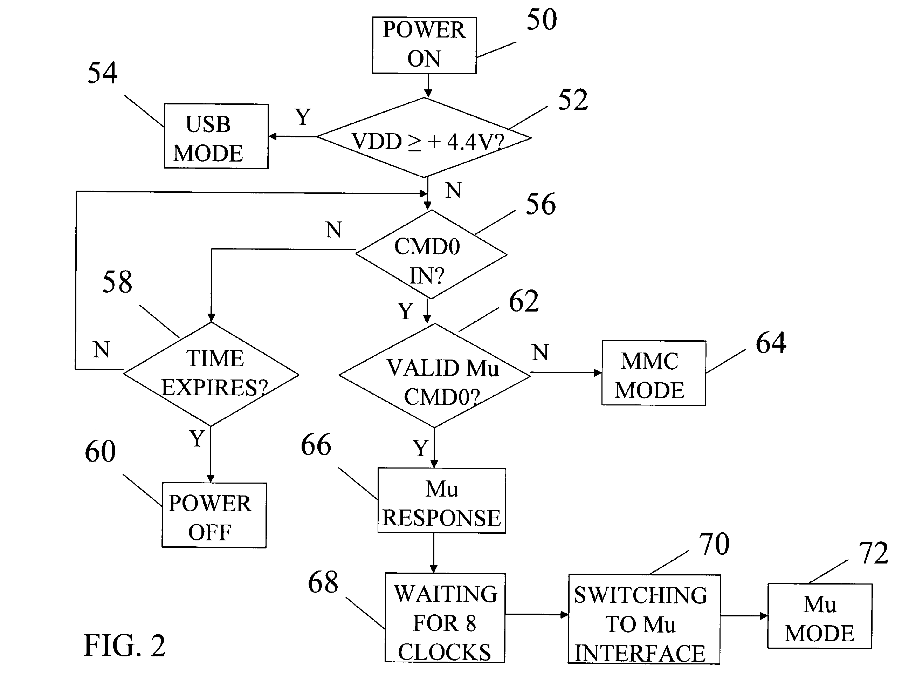

Fig. 2 is a flow diagram of a method for detecting a mode of operation in accordance with one embodiment of the present invention. Referring to Fig. 2, on the device side, host 40 to which electronic device 30 is connected is turned on at step 50. The power source voltage, VDD, for host 40 is detected at step 52 to determine whether the VDD is equal to or greater than a voltage level a USB application requires. Normally, a USB application is operated at a voltage level ranging from approximately 4.5V (volts) to 5.5V, while an MMC or an Mu application is operated at a voltage level of approximately 1.8V or 3.3V. In one embodiment, if the VDD level for host 40 is equal to or greater than 4.4V, a determination is made at step 54 that the mode of operation is USB 2.0. If the VDD level for host 40 is smaller than 4.4V, a determination is made that the mode of operation is either a Mu application or an MMC application.

Next, a determination is made at step 56 whether a command signal CMDO sent from host 40 is received by electronic device 30. Detection of the command signal CMDO is performed within a predetermined time period at step 58. If the predetermined time expires, host 40 is turned off, or "timed out" to save power at step 60. If the predetermined time does not expire, the detection of the command signal continues. When a command signal is received, a determination is made at step 62 whether the command signal indicates a Mu application. If the command signal is not a Mu command signal, a determination is made at step 64 that the mode of operation is an MMC application. If the command signal is determined to be a Mu command signal, electronic device 30 responds to host 40 that the mode of operation is a Mu application at step 66. Electronic device 30 then waits for a predetermined time, for example, 8 clocks, at step 68 for synchronization. Generally, the clock rate depends on the speed of host and system clocks. Electronic device 30 then switches at step 70 to a Mu interface for a Mu application at step 72.

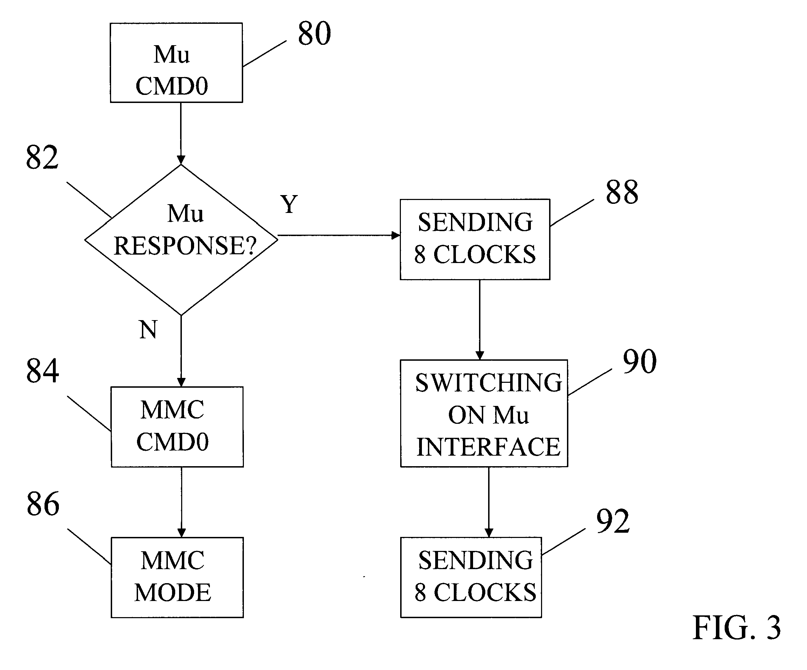

Fig. 3 is another flow diagram of a method for detecting a mode of operation in accordance with one embodiment of the present invention. Referring to Fig. 3, at the host side, host 40 sends a Mu command signal Mu CMD0 to electronic device 30 at step 80. If electronic device 30 at step 82 does not send a response signal, host 40 sends an MMC command signal MMC CMDO at step 84, indicating that the mode of operation is the MMC application at step 86. If electronic device 30 at step 82 replies with a Mu response signal, host 40 sends a predetermined number of clocks, for example, 8 clocks, for synchronization at step 88. Electronic device 30 switches at step 90 to the Mu mode. At step 92, electronic device 30 may optionally send a signal to host 40, indicating that a Mu interface is ready.

By way of example, the command signals MMC CMDO and Mu CMDO are defined in a 6-byte format as "40h, 00h, 00h, 00h, 00h, 95h" and "40h, 4Dh, 55h, BFh, B2h, AAh," respectively. Furthermore, the Mu response signal is defined in a 6-byte format as "19h [4-byte operating parameters] FFh."

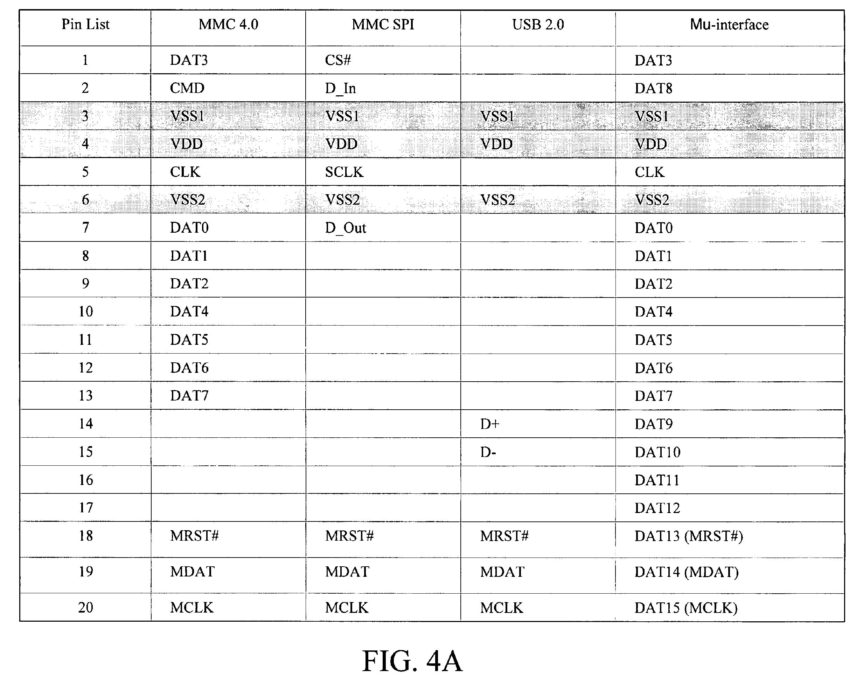

Fig. 4A is a proposed pin assignment chart of a removable electronic device in accordance with one embodiment of the present invention. Referring to Fig. 4A, all of the pins at the device side are kept as HiZ (high impedance) state until a mode of operation between a host and the removable electronic device is determined. The first pin of the removable electronic device for the MMC 4.0 mode, i.e., DAT 3, is defined to switch the MMC 4.0 mode to the MMC SPI mode, which has been defined in the MMC Specification. The second pin for the Mu interface mode, i.e., DAT 8, is used to identify that the MMC mode or Mu interface mode is selected. The fourteenth and fifteenth pins for the USB mode, i.e., D+ and D-, are a pair of data signals, which may be used to determine whether the USB mode is selected. The pair of data signals (D+, D-) is a complementary pair in which one is at a high level when the other is at a low level. Pins 18, 19 and 20 are reserved for SIMM (single in-line memory module) card applications. Thus, the removable electronic device of the present invention is able to support MMC compatible, USB compatible and Mu-interface applications, and simultaneously retains the flexibility of working for the SIMM applications.

An exemplary interface protocol of the present invention is described as follows:

1. SYNC FIELD

(1) 1-bit: DAT = 0b

(2) 4-bit: DAT[3:0] = xxx0b

(3) 8-bit: DAT[7:0] = xxxxxxx0b

(4) 16-bit: DAT[15:0] = xxxxxxxxxxxxxxx0b

Where "x" refers to a condition that is not relevant for the protocol.

2. PID FIELD

(1) 1-bit: LSB first

$$DAT = PID[0]\ PID[1]\ PID[2]\ PID[3]\ nPID[0]\ nPID[1]\ nPID[2]\ nPID[3]$$

(2) 4-bit:

$$DAT[3:0] = PID[3:0]\ nPID[3:0]$$

(3) 8-bit:

$$DAT[7:4] = \text{inverted of } PID[3:0]$$

$$DAT[3:0] = PID[3:0]$$

Where "nPID" refers to an inverted signal of PID. The PID Data transaction is protected by the inverted mirror Data of PID and nPID. The controller in both the host and device sides should verify the validity of the PID. PID Codes are defined in Table 1 given below.

Table 1 PID Codes

| PID Type | PID Name | PID<3:0>* | Description |
|---|---|---|---|
| Token | OUT | 0001B | Address + endpoint number in host-to-function transaction |
| | IN | 1001B | Address + endpoint number in function-to-host transaction |
| | SOF | 0101B | Start-of-Frame marker and frame number |
| | SETUP | 1101B | Address + endpoint number in host-to-function transaction for SETUP to a control pipe |

Table continued

| PID Type | PID Name | PID<3:0>* | Description |
|---|---|---|---|
| Data | DATA0 | 0011B | Data packet PID even |
| | DATA1 | 1011B | Data packet PID odd |
| | DATA2 | 0111B | Data packet PID high-speed, high bandwidth isochronous transaction in a microframe (see Section 5.9.2 for more information) |
| | MDATA | 1111B | Data packet PID high-speed for split and high bandwidth isochronous transactions (see Sections 5.9.2. 11.20. and 11.21 for more information) |
| Handshake | ACK | 0010B | Receiver accepts error-free data packet |
| | NAK | 1010B | Receiving device cannot accept data or transmitting device cannot send data |
| | STALL | 1110B | Endpoint is halted or a control pipe request is not supported |
| | NYET | 0110B | No response yet from receiver (see Sections 8.5.1 and 11.17-11.21) |
| Special | PRE | 1100B | (Token) Host-issued preamble. Enables downstream bus traffic to low-speed devices. |
| | ERR | 1100B | (Handshake) Split Transaction Error Handshake (reuses PRE value) |
| | SPLIT | 1000B | (Token) High-speed Split Transaction Token (see Section 8.4.2) |
| | PING | 0100B | (Token) High-speed flow control probe for a bulk/control endpoint (see Section 8.5.1) PID |
| | Reserved | 0000B | Reserved PID |

Note: PID bits are shown in MSb order. When sent on the USB, the rightmost bit (bit 0) win be sent first.

3. ADDRESS, END POINT, CRC5 FIELD

(1) Address => 7-bit, ADDR[6:0]
(2) End Point => 4-bit, EndP[3:0]
(3) Token CRC => 5-bit, TCRC[4:0]

$$\{ADDR[6:0] \ \& \ EndP[3]\} + \{EndP[2:0] \ \& \ TCRC[4:0]\}$$

Where TCRC is a 5-bit Token CRC, and the CRC on the Mu card is optional. If CRC is turned on, the CRC check must exist on both of the host and device. If, however, CRC is disabled, Wrapper must generate a CRC for a USB controller. Since Default is disabled CRC, there is no CRC field when CRC is disabled.

4. EOP FIELD

(1) 1-bit: DAT0 = 1b

(2) 4-bit: DAT[3:0] = xxx 1b

(3) 8-bit: DAT[7:0] = xxxxxxx1b

(4) 16-bit: DAT[15:0] = xxxxxxxxxxxxxxx 1b

Where "x" refers to a "don't care" condition. For solving an even/odd byte issue on the 16-bit mode transaction, OddByte bit is added on the b [15] of the EOP field. If OddByte=1, then the last byte on the DATA [15:8] is invalid. If OddByte=0, then the last word on the DATA [15:0] is valid.

5. TOKEN PACKET FORMAT

Token Packet is composed of 3-byte SYNC and EOP. The Token packet supports at least the 1-bit, 4-bit and 8-bit modes.

(1) 1-bit: (LSB First)

$$SYNC + PID + ADDR + ENDP + CRC5 + EOP$$

(2) 4-bit: {DAT[3:0]}

$$SYNC + PID + not(PID) + A[3:0] + \{ENDP[0] \& A[6:4]\} + \{CRC0$$

$$\& \ ENDP[3:1]\} + CRC[5:1] + EOP$$

(3) 8-bit mode: {DAT[7:0]}

$$SYNC + \{not(PID) \& PID\} + \{EP[0] \& A[6:0]\} + \{TCRC[4:0] \&$$

$$EP[3:1]\} + EOP$$

5.1. Start-of-Frame Format

$$SYNC + \{not(PID) \& PID\} + \{FN[10:3]\} + \{FN[2:0] \& TCRC[4:0]\}$$

$$+ EOP$$

Where FN refers to Frame Number.
6. DATA PACKET FORMAT

6.1. Data Field Format

(i) 1-bit: (LSB first)

| DAT0 | D7 | | D0 | D1 | D2 | D3 | D4 | D5 | D6 | D7 | | D0 |
|------|----|----|----|----|----|----|----|----|----|----|----|----|

Byte N-1              Byte N              Byte N+1

(ii) 4-bit

|       | DAT3 | D7 |    | D3 | D7 |    | D3 | D7 |
|-------|------|----|----|----|----|----|----|----|
|       | DAT2 | D6 |    | D2 | D6 |    | D2 | D6 |
|       | DAT1 | D5 |    | D1 | D5 |    | D1 | D5 |
|       | DAT0 | D4 |    | D0 | D4 |    | D0 | D4 |

Byte N-1        Byte N        Byte N+1

(iii) 8-bit

DAT7

Byte N-1    Byte N    Byte N+1

DAT0

(iv) 16-bit

DAT15

Byte N-1    Byte N+1    Byte N+3

DAT8
DAT7

Byte N-2    Byte N    Byte N+2

DAT0

Where the 16-bit mode is used only in Data Packet.

6.2. Data Packet Format

SYNC + {not(PID) & PID} + {DAT[7:0]}*(0~1024) + {DCRC[15:8]} +

{DCRC[7:0]} + EOP

Where DCRC is Data CRC with 16-bit Polynomial: $X^{16}+X^{15}+X^2+1$ (SEED = 800Dh)

7. HANDSHAKE PACKET FORMAT

(1) 1 -bit: (LSB First)

$$SYNC + PID + EOP$$

(2) 4-bit: {DAT[3:0]}

$$SYNC + PID + not(PID) + EOP$$

(3) 8-bit mode: {DAT[7:0]}

$$SYNC + \{not(PID) \& PID\} + EOP$$

8. SPECIAL PACKET FORMAT

8.1. Ping Format

(i) 1-bit: (LSB First)

$$SYNC + PID + ADDR + ENDP + CRC5 + EOP$$

(ii) 4-bit: {DAT[3:0]}

$$SYNC + PID + not(PID) + A[3:0] + \{ENDP[0] \& A[6:4]\} + \{CRC0 \&$$

$$ENDP[3:1]\} + CRC[5:1] + EOP$$

(iii) 8-bit mode: {DAT[7:0]}

$$SYNC + \{not(PID) \& PID\} + \{EP[0] \& A[6:0]\} + \{TCRC[4:0] \& EP[3:1]\}$$

$$+ EOP$$

9. TRANSFER TYPES
The Transfer Types are inherent from the USB standard, including (1) Control, (2) Interrupt, (3) Bulk, and (4) Isochronous.

10. SIGNAL INTEGRITY
A signal or data transportation in the bus has 3 kinds of protections:

(1) PID is protected by inverted mirror of PID and nPID. Where the nPID is an inverted signal of PID.
(2) Token Packet and Start-of-Frame are protected by CRC5, of which the Polynomial and the seed are as follows:

$$X^5+X^2+1 \text{ with SEED} = 01100b$$

(3) Data Packet is protected by CRC16, of which the Polynomial and the seed are as follows:

$$X^{16}+X^{15}+X^2+1 \text{ with SEED} = 800Dh$$

11. BUS WIDTH AND SETTING

The device is powered at the 1-bit bus mode. The host can set the bus width of 1-bit (initial), 4-bit, 8-bit, or 16-bit to be operated on both sides.

(1) 1-bit: Token (1-bit), Handshake (1-bit), Special (1-bit), Data (1-bit).
(2) 4-bit: Token (4-bit), Handshake (4-bit), Special (4-bit), Data (4-bit).
(3) 8-bit: Token (8-bit), Handshake (8-bit), Special (8-bit), Data (8-bit).
(4) 16-bit: Token (8-bit), Handshake (8-bit), Special (8-bit), Data (16-bit).

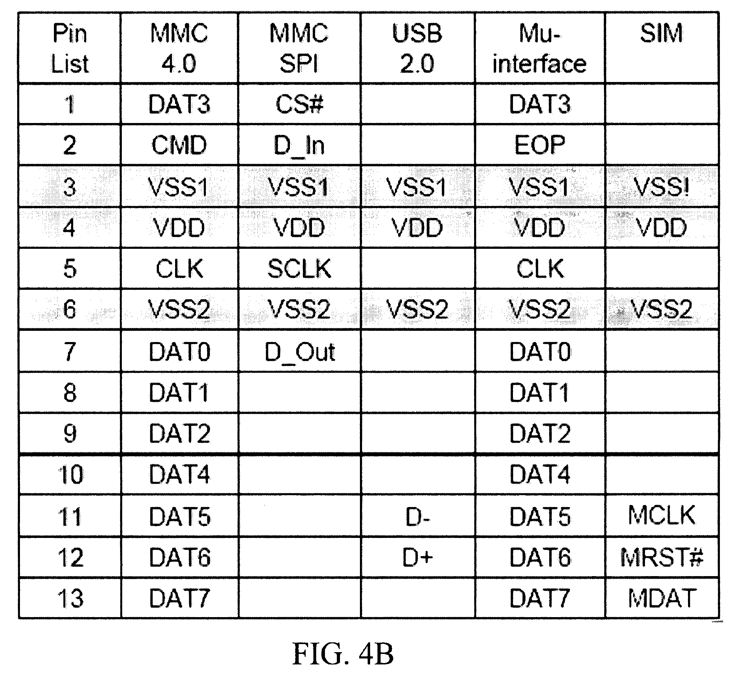

Fig. 4B is a proposed pin assignment chart of a removable electronic device in accordance with another embodiment of the present invention. Unlike the 20-pin assignment for a 16-bit application illustrated in Fig. 4A, Fig. 4B illustrates a 13-pin assignment for an 8-bit application. The eleventh and twelfth pins for the USB mode, defined for D- and D+, respectively, are used to determine whether the USB mode is selected. Furthermore, pins 11, 12 and 13 are defined for SIMM card applications.

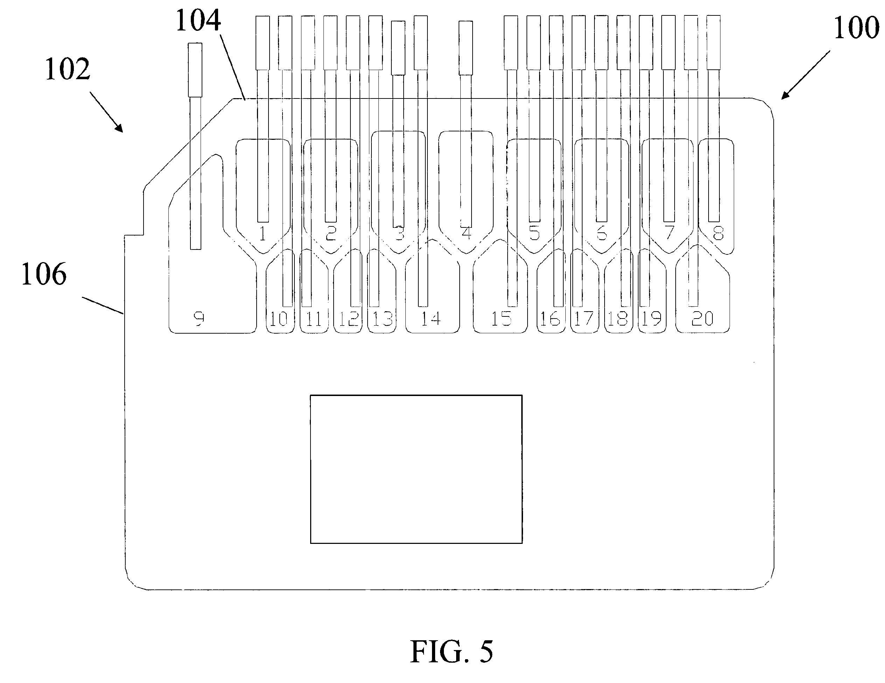

Fig. 5 is a diagram of a removable electronic device 100 in accordance with one embodiment of the present invention. Referring to Fig. 5, electronic device 100 includes a notch 102 on the upper left-hand corner to prevent incorrect insertion of electronic device 100. In addition, notch 102 and related counter parts serve to allow for backward compatibility of MMC and USB applications, but not vice versa. In one aspect, notch 102 intersects the adjacent sides 104 and 106 with substantially the same angle, approximately 45 degrees.

Electronic device 100 also includes a plurality of interweaving contact pads labeled 1 to 20, which correspond to the pins illustrated in Fig. 4A. The interweaving design in the contact pads allows additional pins to be present in the same real estate. As a result, a different number of contact pads may alternately be used. The contact pads, connected with a memory circuit chip (not shown) within electronic device 100, are positioned in twenty recesses on a top surface along front side 104 and notch 102. The contact pads may be divided into a first row and a second row. Each of the contact pads includes a substantially tapered end such that contact pads of the first row are arranged with the corresponding contact pads of the second row by their substantially tapered ends. The substantially tapered ends allow smooth contact with the host's contact terminals.

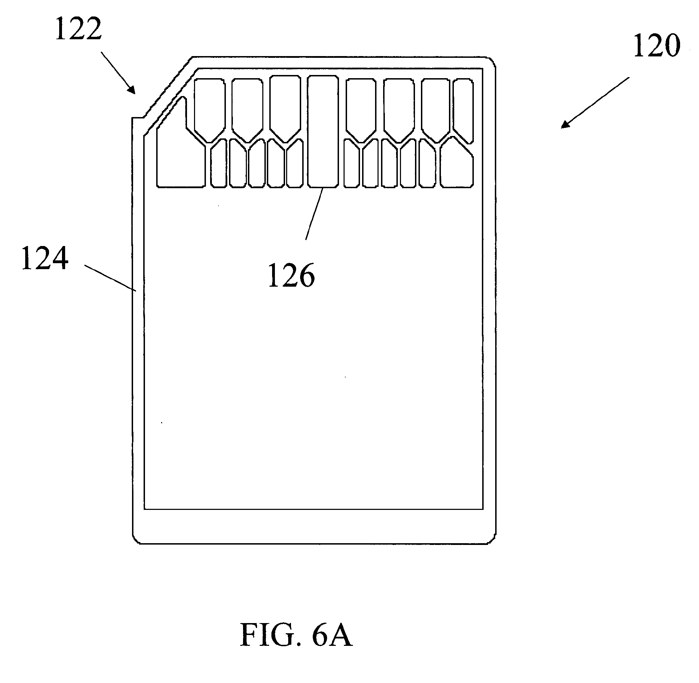

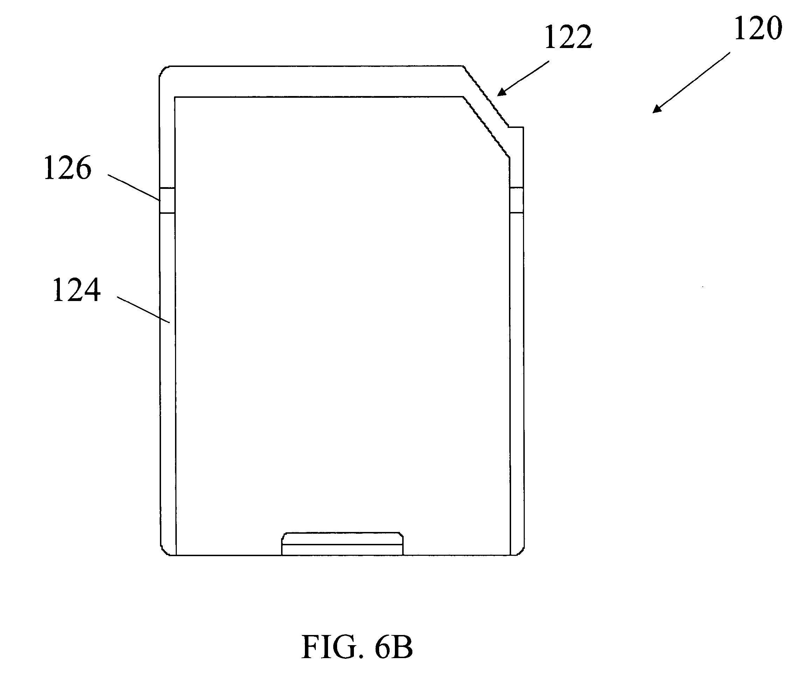

Figs. 6A and 6B are diagrams of a removable electronic device 120 in accordance with another embodiment of the present invention. Fig. 6A is a top view of electronic device 120 having a housing (not numbered). Referring to Fig. 6A, the housing includes a top surface, a bottom surface and a periphery. Electronic device 120 includes a notch 122 and a substantially "U-shaped" indentation 124 on the periphery of the housing to allow for a low-profile design. Specifically, indentation 124 allows a card reader (not shown) in the host to grasp electronic device 120 and secure electronic device 120 through indentation 124, as opposed to the conventional application of using the bulk of the memory card to secure its position in the host. As such, the notch design of the memory card of the present invention obviates this consideration in the memory card design and in turn allows the design of the memory card to be minimized. Accordingly, the profile of the card reader in the host may also be minimized.

In addition to a plurality of interweaving contact pads (not numbered) positioned in a first row and a second row, electronic device 120 includes a contact pad 128 extending across the first row to the second row. In one embodiment, the total number of the first row of contact pads and the second row of contact pads is 20.

Fig. 6B is a bottom view of electronic device 120. Referring to Fig. 6B, electronic device 120 includes additional indentations 126 on the periphery to allow for locking of electronic device 120 to the housing at the host side.

It will be appreciated by those skilled in the art that changes could be made to the embodiments described above without departing from the broad inventive concept thereof. It is understood, therefore, that this invention is not limited to the particular embodiments disclosed, but it is intended to cover modifications within the spirit and scope of the present invention as defined by the appended claims.

**Claims**

1. A removable electronic device having an application module for transferring data to or from a host having a plurality of contact terminals, the device comprising:

   a first row of contact pads, each of the contact pads of the first row including a substantially tapered end; and
   a second row of contact pads, each of the contact pads of the second row including a substantially tapered end that corresponds to the substantially tapered end of at least one of the contact pads of the first row in an interweaving relationship,
   wherein the first and second rows of contacts pads are configured to receive the plurality of contact terminals.

2. The device of claim 1, further comprising a contact pad extending across the first row and the second row of contact pads.

3. The device of claim 1, further comprising a substantially U-shaped indentation on a periphery of the removable electronic device.

4. The device of claim 1, further comprising a notch formed in a corner of the removable electronic device.

5. The device of claim 1, wherein the total number of the first row of contact pads and the second row of contact pads is 13.

6. The device of claim 1, wherein at least one of the first row of contact pads or of the second row of contact pads is defined for a single-in-line memory module application.

7. The device of claim 1, wherein the application module includes one of a memory storage or an input/output (I/O)) interface.

8. A removable electronic device having an application module for transferring data to or from a host, comprising:

   a housing having a top surface, a bottom surface and a periphery;
   a plurality of rows of interweaving contact pads formed on the top surface of the housing;
   a substantially U-shaped indentation on the periphery of the housing; and
   a notch on a corner of the housing for securing the device to the host when the device is connected to the host.

9. The device of claim 8, wherein the plurality of rows of interweaving contact pads include a first row of contact pads and a second row of contact pads, each of the first row of contact pads having a substantially tapered end that corresponds to a substantially tapered end of at least one of the second row of contact pads.

10. The device of claim 8, further comprising contact pads for single in-line memory module (SIMM) card application.

11. The device of claim 8, wherein the application module includes one of a memory storage or an input/output (I/O) interface.

12. A removable electronic device having an application module for transferring data to or from a host, comprising:

   a housing having a top surface, a bottom surface and a periphery;
   a substantially U-shaped indentation on the periphery of the housing; and
   a notch on a corner of the housing for securing the device to the host when the device is connected to the host.

13. The device of claim 12, further comprising a plurality of rows of interweaving contact pads include a first row of contact pads and a second row of contact pads, each of the first row of contact pads having a substantially tapered end that corresponds to a substantially tapered end of at least one of the second row of contact pads.

14. The device of claim 12, wherein the application module includes one of a memory storage or an input/output (I/O) interface.

15. A removable electronic device having an application module for transferring data to or from a host, comprising:

a housing having a top surface, a bottom surface and a periphery;
a plurality of rows of interweaving contact pads formed on the top surface of the housing; and
a substantially U-shaped indentation on the periphery of the housing.

16. The device of claim 15, wherein the plurality of rows of interweaving contact pads include a first row of contact pads and a second row of contact pads, each of the first row of contact pads having a substantially tapered end that corresponds to a substantially tapered end of at least one of the second row of contact pads.

17. The device of claim 15, further comprising a notch on a corner of the housing for securing the device to the host when the device is connected to the host.

18. The device of claim 15, wherein the application module includes one of a memory storage or an input/output (I/O) interface.

19. A removable electronic device having an application module for transferring data to or from a host, comprising:

a housing having a top surface, a bottom surface and a periphery;
a plurality of rows of interweaving contact pads formed on the top surface of the housing; and
a notch on a corner of the housing for securing the device to the host when the device is connected to the host.

20. The device of claim 19, wherein the plurality of rows of interweaving contact pads include a first row of contact pads and a second row of contact pads, each of the first row of contact pads having a substantially tapered end that corresponds to a substantially tapered end of at least one of the second row of contact pads.

21. The device of claim 19, further comprising a substantially U-shaped indentation on the periphery of the housing.

22. The device of claim 19, wherein the application module includes one of a memory storage or an input/output (I/O) interface.

FIG. 1A

30
38 APPLICATION MODULE
37 USB DEVICE CONTROLLER
34 MMC DEVICE CONTROLLER
35 WRAPPER
36 USB PHY
32 IF MODE DETECTOR
42
40 NoteBook PC

FIG. 1B

FIG. 1C

FIG. 2

EP 1 632 886 A1

EP 1 632 886 A1

```
            ┌──────────┐           80
            │    Mu    │
            │   CMD0   │
            └──────────┘
                 │
                 ▼
           ◇◇◇◇◇◇◇◇◇◇◇                              ┌──────────────┐      88
  82      ◇             ◇          Y                │   SENDING    │
          ◇    Mu       ◇ ──────────────────────▶  │   8 CLOCKS   │
          ◇  RESPONSE?  ◇                           └──────────────┘
          ◇             ◇                                  │
           ◇◇◇◇◇◇◇◇◇◇◇                                     ▼
                 │ N                                ┌──────────────┐      90
                 ▼                                  │  SWITCHING   │
  84      ┌──────────┐                              │   ON Mu      │
          │   MMC    │                              │  INTERFACE   │
          │   CMD0   │                              └──────────────┘
          └──────────┘                                     │
                 │                                         ▼
  86             ▼                                  ┌──────────────┐      92
          ┌──────────┐                              │   SENDING    │
          │   MMC    │                              │   8 CLOCKS   │
          │   MODE   │                              └──────────────┘
          └──────────┘
```

FIG. 3

| Pin List | MMC 4.0 | MMC SPI | USB 2.0 | Mu-interface |
|---|---|---|---|---|
| 1 | DAT3 | CS# | | DAT3 |
| 2 | CMD | D_In | | DAT8 |
| 3 | VSS1 | VSS1 | VSS1 | VSS1 |
| 4 | VDD | VDD | VDD | VDD |
| 5 | CLK | SCLK | | CLK |
| 6 | VSS2 | VSS2 | VSS2 | VSS2 |
| 7 | DAT0 | D_Out | | DAT0 |
| 8 | DAT1 | | | DAT1 |
| 9 | DAT2 | | | DAT2 |
| 10 | DAT4 | | | DAT4 |
| 11 | DAT5 | | | DAT5 |
| 12 | DAT6 | | | DAT6 |
| 13 | DAT7 | | | DAT7 |
| 14 | | | D+ | DAT9 |
| 15 | | | D- | DAT10 |
| 16 | | | | DAT11 |
| 17 | | | | DAT12 |
| 18 | MRST# | MRST# | MRST# | DAT13 (MRST#) |
| 19 | MDAT | MDAT | MDAT | DAT14 (MDAT) |
| 20 | MCLK | MCLK | MCLK | DAT15 (MCLK) |

FIG. 4A

EP 1 632 886 A1

| Pin List | MMC 4.0 | MMC SPI | USB 2.0 | Mu-interface | SIM |
|---|---|---|---|---|---|
| 1 | DAT3 | CS# | | DAT3 | |
| 2 | CMD | D_In | | EOP | |
| 3 | VSS1 | VSS1 | VSS1 | VSS1 | VSS! |
| 4 | VDD | VDD | VDD | VDD | VDD |
| 5 | CLK | SCLK | | CLK | |
| 6 | VSS2 | VSS2 | VSS2 | VSS2 | VSS2 |
| 7 | DAT0 | D_Out | | DAT0 | |
| 8 | DAT1 | | | DAT1 | |
| 9 | DAT2 | | | DAT2 | |
| 10 | DAT4 | | | DAT4 | |
| 11 | DAT5 | | D- | DAT5 | MCLK |
| 12 | DAT6 | | D+ | DAT6 | MRST# |
| 13 | DAT7 | | | DAT7 | MDAT |

FIG. 4B

EP 1 632 886 A1

FIG. 5

FIG. 6A

EP 1 632 886 A1

FIG. 6B

EP 1 632 886 A1

**European Patent Office**

**EUROPEAN SEARCH REPORT**

Application Number

EP 05 01 8993

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2004/070952 A1 (HIGUCHI AKIRA ET AL) 15 April 2004 (2004-04-15) * abstract; figures 1-30 * * paragraph [0064] - paragraph [0141] * | 1,2,4, 6-20,22 | G06K19/077 H05K1/11 H01R13/24 |
| Y | US 5 061 190 A (MEDEIORS ET AL) 29 October 1991 (1991-10-29) * abstract; figures * * column 4, line 7 - column 6, line 17 * | 1,2,4, 6-20,22 | |
| A | US 6 142 802 A (BERG ET AL) 7 November 2000 (2000-11-07) * abstract; figure 8 * * column 6, line 17 - line 24 * | 2 | |
| A | "PAD PATTERN FOR HOT BAR SOLDERING" IBM TECHNICAL DISCLOSURE BULLETIN, IBM CORP. NEW YORK, US, vol. 40, no. 2, February 1997 (1997-02), pages 65-66, XP000692171 ISSN: 0018-8689 * the whole document * | 1,8,12, 15,19 | |
| A | ENTERKIN R ET AL: "EQUIPMENT/MATERIAL SYNERGISM KEY TO SOLDER PASTE PRINTING" ELECTRONIC PACKAGING AND PRODUCTION, CAHNERS PUBLISHING CO, NEWTON, MASSACHUSETTS, US, vol. 31, no. 5, 1 May 1991 (1991-05-01), pages 136-138, XP000207898 ISSN: 0013-4945 * page 3 - page 3 * | 1,8,12, 15,19 | TECHNICAL FIELDS SEARCHED (IPC) G06K H01R H05K |
| A | US 6 056 573 A (NISHIOKA ET AL) 2 May 2000 (2000-05-02) * abstract; figures 1,3 * * column 3, line 26 - column 7, line 6 * | 1,8,12, 15,19 | |

The present search report has been drawn up for all claims

| Place of search | Date of completion of the search | Examiner |
|---|---|---|
| Munich | 12 December 2005 | Serrano Funcia, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                      
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 01 8993

This annex lists the patent family members relating to the patent documents cited in the above-mentioned European search report.
The members are as contained in the European Patent Office EDP file on
The European Patent Office is in no way liable for these particulars which are merely given for the purpose of information.

12-12-2005

| Patent document cited in search report | | Publication date | Patent family member(s) | | Publication date |
|---|---|---|---|---|---|
| US 2004070952 | A1 | 15-04-2004 | AU 2003271153 A1<br>WO 2004034318 A1<br>JP 2005284323 A | | 04-05-2004<br>22-04-2004<br>13-10-2005 |
| US 5061190 | A | 29-10-1991 | NONE | | |
| US 6142802 | A | 07-11-2000 | US 6074228 A<br>US 6648693 B1 | | 13-06-2000<br>18-11-2003 |
| US 6056573 | A | 02-05-2000 | JP 3527812 B2<br>JP 10050428 A | | 17-05-2004<br>20-02-1998 |

EPO FORM P0459

For more details about this annex : see Official Journal of the European Patent Office, No. 12/82